# EUROPEAN PATENT APPLICATION

(11) **EP 4 444 065 A1**
(43) Date of publication of application: **09.10.2024**
(21) Application number: 22901902.1
(22) Date of filing: 05.12.2022
(51) Int. Cl.: H10K 71/00, H01L 21/285, H01L 21/027, H10K 99/00, H10K 50/80, H10K 50/00, C23C 14/04, C23C 14/14, C23C 14/56

(54) **METAL ELECTRODE PATTERNING METHOD USING PATTERN FORMATION CONTROL MATERIAL, AND SUBSTRATE, ELECTRONIC DEVICE, AND DISPLAY HAVING METAL ELECTRODE PATTERN**

(30) Priority: 03.12.2021 KR 20210171592; 28.07.2022 KR 20220093976
(71) Applicant: Seoul National R&BD Foundation, Seoul 08826 (KR)
(72) Inventor: HONG, Yong Taek, Seoul 08826 (KR); JEONG, Su Jin, Seoul 08826 (KR)
(74) Representative: TRBL Intellectual Property
(86) International application number: PCT/KR2022/019648
(87) International publication number: WO 2023/101544

(57) **Abstract**

The metal electrode patterning method using a pattern formation control material according to one example of the present invention may comprise printing a pattern formation control material on a substrate in an engraved pattern; heat-treating the printed pattern formation control material; and forming a conductive metal electrode pattern in a region other than the engraved pattern-printed region, and the region in which the pattern formation control material is printed may have light transmittance.

## Description

### [TECHNICAL FIELD]

Related are a metal electrode patterning method using a pattern formation control material and a substrate having a metal electrode pattern, and more specifically, related are a method for patterning a metal electrode using a pattern formation control material without a conventionally generally used metal mask and a substrate having a metal electrode pattern.

### [BACKGROUND ART]

Formation of a conductive metal pattern using vacuum deposition is a technology that is used in various fields, such as forming a metal wire for electric and electronic circuits, or forming an electrode of an OLED light emitting device and a semi-conductor device for a display, and the like.

The most common method for forming a conductive metal pattern using a deposition process is using metal mask, and in general, it is a method of physically removing a metal from the part where a pattern is formed by processing an alloy with a low thermal expansion coefficient, and selectively deposing an electrode through the removed part. Such a method is accompanied by limitations that the difficulty of high resolution and large-area implementation is high, which is accompanied by the use of a metal mask.

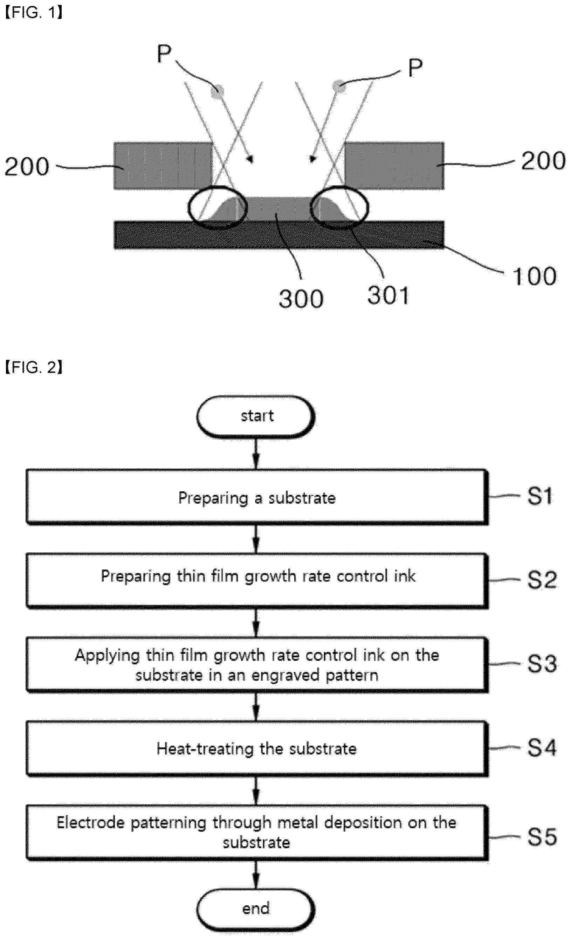

FIG. 1 is a drawing to describe a shadow effect occurring in a conventional deposition process using a mask. In the prior art shown in FIG. 1, metal particles (P) are deposited on a substrate through a deposition process using a metal mask (200) to form a metal pattern (300) on the substrate (100).

In the patterning method using the metal mask (200), the amount deposited in the boundary region (301) of the metal pattern (300) becomes smaller than that in the center due to a shadow effect occurring at the boundary of the mask (200). Due to this, the patterning method using the metal mask (200) has a problem in that it is difficult to form a micropattern. For this reason, in order to increase resolution, research and development on a technology of processing a thin metal mask with a thickness of 20 µm or less have been progressed, but there is a problem in that the manufacturing difficulty increases as the metal mask becomes thinner and the unit cost of the metal mask increases. In addition, the patterning method using the metal mask acts as a limitation in large-area patterning, as the metal mask becomes thinner and larger, a sagging phenomenon of the mask may occur.

In addition, recently, manufacturing of electronic devices and circuits has been expanded to various types of curved substrates and flexible substrates beyond hard glass and silicon substrates. However, conventional metal masks are difficult to process into a curved surface, and have flexibility insufficient to attach a metal mask on a substrate of the curved surface, so there is possibility to occur permanent deformation. Therefore, there is a problem in that it is difficult to apply a patterning method using the conventional metal mask to a curved substrate and/or a flexible substrate.

### [DISCLOSURE]

### [TECHNICAL PROBLEM]

The present invention is to solve the aforementioned problems of the prior art, and an object of the present invention is to provide a metal electrode patterning method and a substrate having a metal electrode pattern, which can overcome limitations in high resolution or large-area pattern formation by progressing patterning of a metal electrode without a metal mask in a deposition process, and can omit a metal mask aligning process in the deposition process, thereby reducing process steps.

### [TECHNICAL SOLUTION]

In order to achieve the above object, the metal electrode patterning method using a pattern formation control material according to one example of the present invention may comprise printing a pattern formation control material on a substrate in an engraved pattern; heat-treating the printed pattern formation control material; and forming a conductive metal electrode pattern in a region other than the engraved pattern-printed region, and the region in which the pattern formation control material is printed may have light transmittance.

In addition, the metal electrode pattern may be a high-purity metal electrode pattern formed by physical vapor deposition (PVD).

Furthermore, the metal electrode patterning method using a pattern formation control material may further comprise designing the engraved pattern before the printing the engraved pattern on the substrate.

Moreover, the pattern formation control material is ink comprising PVDF-HFP (Poly(vinylidene fluoride-co-hexafluoropropylene)).

In addition, the pattern formation control material further comprises a solvent, and the solvent comprises one alone selected from the group consisting of NMP (N-methyl-2-pyrrolidone), TEP (Triethyl phosphate), DMSO (Dimethyl sulfoxide), MIBK (Methyl isobutyl ketone), and PGMEA (Propylene glycol methyl ether acetate), or a mixture thereof. Furthermore, the pattern formation control material further comprises a cross-linking agent, and the cross-linking agent comprises one alone selected from the group consisting of TAIC (1,3,5-Triallyl-1,3,5-triazinane-2,4,6-trione, BPO (dibenzoyl peroxide), DCP (Dicumyl peroxide), PBP (Perbutyl peroxide), MIKP (Methyl isobutyl ketone peroxide), and Dimethyl Di-t-butylperoxy hexane, or a mixture thereof.

Moreover, the pattern formation control material comprises 1 to 50 % by weight of the PVDF-HFP, 0.05 to 3 % by weight of the cross-linking agent and the solvent as a remaining component.

In addition, the engraved pattern comprises a plurality of printing regions in which the pattern formation control material is printed, and each of the printing regions is not connected to other printing regions.

Furthermore, the metal electrode pattern forms a pattern consisting of dot, circle, oval, polygon and ring shapes or a combination thereof.

Moreover, the heat-treating is performed in a temperature range of 100°C to 150°C.

In addition, metal particles on the metal electrode pattern are more uniformly distributed than particles distributed in the region in which the pattern formation control material is applied.

Furthermore, a transition region is formed between the region in which the metal electrode pattern is formed and the region in which the pattern formation control material is printed. Moreover, the transition region comprises an inclined surface having an angle of 0.5° to 10° with respect to the substrate.

In addition, the size of the metal particles formed in the region in which the pattern formation control material is applied is smaller than 200nm.

Furthermore, the metal deposited on the substrate comprises one alone selected from the group consisting of gold (Au), silver (Ag), magnesium (Mg), copper (Cu), iron (Fe), and calcium (Ca) or a combination thereof.

Moreover, the formation of the metal electrode pattern is performed by a roll-to-roll deposition method.

The substrate having a metal electrode pattern according to another example of the present invention, may comprise a region in which a pattern formation control material is printed on the substrate; and a region in which a conductive metal electrode pattern is formed on the substrate, and the region in which the metal electrode pattern is formed may be a region other than the region in which the pattern formation control material is printed, and the region in which the pattern formation control material is printed may be formed by printing and drying the pattern formation control material by a printing process and have light transmission, and the metal electrode pattern may be a high-purity metal electrode pattern formed by PVD.

In addition, metal particles on the metal electrode pattern are more uniformly distributed than particles distributed in the region in which the pattern formation control material is applied.

Furthermore, a transition region is formed between the region in which the metal electrode pattern is formed and the region in which the pattern formation control material is printed. Moreover, the transition region comprises an inclined surface having an angle of 0.5° to 10° with respect to the substrate.

The display according to other example of the present invention, may comprise a substrate; a region in which a pattern formation control material is printed on the substrate; a region in which a conductive metal electrode pattern is formed on the substrate; and at least one light emitting device electrically connected to the metal electrode pattern, and the region in which the metal electrode pattern is formed may be a region other than the region in which the pattern formation control material is printed, and the region in which the pattern formation control material is printed may be formed by printing and drying the pattern formation control material by a printing process and have light transmission, and the metal electrode pattern may be a high-purity metal electrode pattern formed by PVD.

In addition, the region in which the pattern formation control material is printed may be formed on the upper portion and lower portion of the light emitting device, respectively, and the metal electrode pattern may be formed in a region other than the pattern formation control material is printed and may be electrically connected to the light emitting device. The electronic apparatus according to other example of the present invention, may comprise a substrate; a region in which a pattern formation control material is printed on the substrate; a region in which a conductive metal electrode pattern is formed on the substrate; and at least one electronic device electrically connected to the metal electrode pattern, and the region in which the metal electrode pattern is formed may be a region other than the region in which the pattern formation control material is printed, and the region in which the pattern formation control material is printed may be formed by printing and drying the pattern formation control material by a printing process and have light transmission, and the metal electrode pattern may be a high-purity metal electrode pattern formed by PVD.

### [ADVANTAGEOUS EFFECTS]

According to the metal electrode patterning method using a pattern formation control material according to one example of the present invention, as no metal mask is used in all process steps, limitations in high resolution or large-area pattern formation which may accompany thereby can be overcome, and a process step of aligning a substrate and a metal mask can be omitted, so a process method can be simplified. In addition, the examples of the present invention can form an electrode pattern which is difficult to pattern with a single mask at one time such as a hole-formed pattern, a ring-shaped pattern, and the like, and in addition, thin film growth rate control ink which is a pattern formation control material is coated based on a printing process, so the pattern can be freely changed.

The process of applying a pattern formation control material is based on a solution process, so large-area application is easy at low cost, and thus it has an advantageous aspect in terms of mass production. In addition, the pattern formation control material has a flexible characteristic, so it is also possible to apply it to a flexible substrate by a roll-to-roll continuous production method. Since the deposition process can be also implemented as roll-to-roll as the use of a separate metal mask for patterning is not required during deposition, it has an advantage of being able to develop a process technology that reduces production costs in the aspect of mass production, and at the same time, it can reduce process steps in the deposition system of the roll-to-roll method. In particular, in the display field, for OLED lighting, roll-to-roll vacuum deposition has an advantage of increasing mass production compared to the conventional sheet-to-sheet method.

### [BRIEF DESCRIPTION OF THE DRAWINGS]

FIG. 1 is a diagram to describe a shadow effect occurring in a conventional deposition process using a mask.
FIG. 2 is a flowchart of the metal electrode patterning method using a pattern formation control material according to one example of the present invention.
FIG. 3 is a schematic diagram to describe the metal electrode patterning method using a pattern formation control material according to one example of the present invention.
FIG. 4 is diagrams showing the results of performing the metal electrode patterning method using a pattern formation control material according to one example of the present invention.
FIG. 5 is a drawing showing an example of a metal mask which can be practically manufactured.
FIGs. 6 and 7 are drawings to describe a formable metal electrode pattern using the metal electrode patterning method using a pattern formation control material according to one example of the present invention.
FIG. 8 is drawings showing the selective patterning result of Ag by the metal electrode patterning method using a pattern formation control material according to one example of the present invention.
FIG. 9 is a drawing showing the result of measuring transmittance of the Ag region/PVDF-HFP applied region illustrated in FIG. 8.
FIG. 10 is drawings showing one example of shapes in which a shadow effect is improved by the metal electrode patterning method using a pattern formation control material according to one example of the present invention.
FIG. 11 is drawings showing another example of shapes in which a shadow effect is improved by the metal electrode patterning method using a pattern formation control material according to one example of the present invention.
FIG. 12 is a drawing showing results of printing various metal materials by the metal electrode patterning method using a pattern formation control material according to one example of the present invention.
FIG. 13 is a drawing showing a process of forming an electrode pattern by the metal electrode patterning method using a pattern formation control material according to one example of the present invention.

### [MODE FOR INVENTION]

Hereinafter, the examples of the present invention will be described in detail with reference to the accompanying drawings. In adding reference numerals to elements of each drawing, it should be noted that the same elements have the same numerals as much as possible even if they are indicated on different drawings. In addition, in describing the examples of the present invention, when it is determined that a detailed description of related known composition or functions hinders understanding of the examples of the present invention, the detailed description will be omitted.

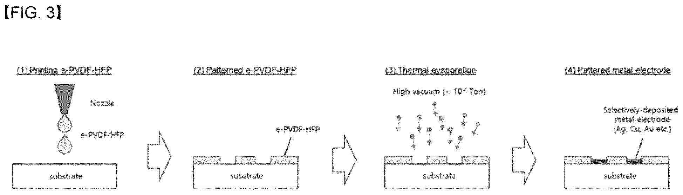

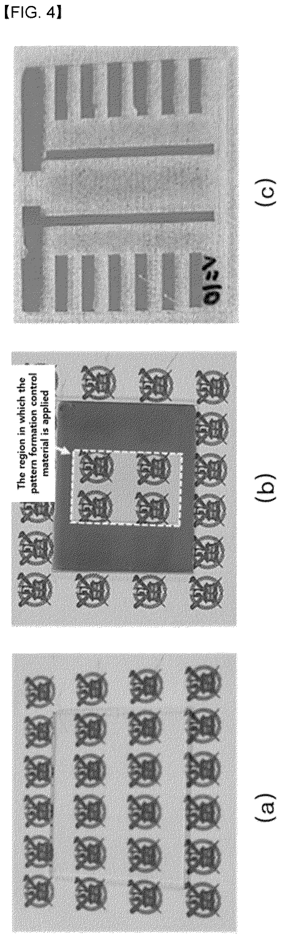

FIG. 2 is a flowchart of the metal electrode patterning method using a pattern formation control material according to one example of the present invention, and FIG. 3 is a schematic diagram to describe the metal electrode patterning method using a pattern formation control material according to one example of the present invention, and FIG. 4 is diagrams showing the results of performing the metal electrode patterning method using a pattern formation control material according to one example of the present invention.

Referring to FIG. 2 to FIG. 4, the metal electrode patterning method using a pattern formation control material according to one example of the present invention relates to a method for forming a conductive metal pattern by selectively depositing a metal on a substrate through coating of the pattern formation control material.

The deposition process is a method of coating a thin film by evaporating a source to be deposited in a chamber in a high-vacuum state into a gas state, and may be used for forming a metal wire for electric and electronic circuits or forming an electrode of an OLED light emitting device and a semi-conductor device for a display. In particular, when a metal film is formed using the deposition process, a pure metal film having excellent surface roughness and high conductivity can be coated, and also, film formations even with a thin thickness of several nm, so it can be also used for implementing an electrode having high transmission.

The metal electrode patterning method using a pattern formation control material according to the examples of the present invention can form a conductive metal pattern on a substrate based on a deposition process without the use of a metal mask through a method of coating a substance capable of controlling growth of a metal deposited thin film on a substrate.

More specifically, the metal electrode patterning method using a pattern formation control material according to the examples of the present invention may comprise preparing a substrate (S1), preparing thin film growth rate control ink (S2), applying the thin film growth rate control ink on the substrate in an engraved pattern (S3), and patterning an electrode on the substrate through metal deposition (S4). Hereinafter, a detailed description of each step will be given.

A substrate in which a metal electrode pattern is formed is prepared (S1). The type of the substrate to be used in the examples of the present invention is not particularly limited, and various substrates may be used. According to various uses, various substrates may be used. For example, the substrate may include a flexible substrate, a curved substrate, a bendable substrate, a stretchable substrate and the like. In addition, the surface properties of the substrate may be hydrophilic or hydrophobic. As a specific example, the substrate may be a substrate made of wafer, glass, or polymers.

Next, thin film growth rate control ink is prepared (S2). The thin film growth rate control ink, in other words, a substance which controls growth of the deposited thin film is prepared in a transparent ink form in which a solution process is possible.

The pattern formation control material comprises a fluorine functional group and comprises a polymer material having low surface energy (for example, Poly(vinylidene fluoride-co-hexafluoropropylene); PVDF-HFP). The pattern formation control material may be applied using a solution process and is prepared as transparent ink.

In order to have physical properties (for example, viscosity, surface tension, boiling point, etc.) suitable for printing equipment, the pattern formation control material may comprise various solvents such as N-methyl-2-pyrrolidone (NMP), Triethyl phosphate (TEP), Dimethyl sulfoxide (DMSO), Methyl isobutyl ketone (MIBK), Propylene glycol methyl ether acetate (PGMEA), and the like.

In addition, the pattern formation control material may further comprise a cross-linking agent, to secure mechanical flexibility of the printed PVDF-HFP pattern.

The cross-linking agent may comprise one alone selected from the group consisting of TAIC (1,3,5-Triallyl-1,3,5-triazinane-2,4,6-trione, BPO (dibenzoyl peroxide), DCP (Dicumyl peroxide), PBP (Perbutyl peroxide), MIKP (Methyl isobutyl ketone peroxide), and Dimethyl Di-t-butylperoxy hexane, or a mixture thereof.

The composition ratio of the aforementioned pattern formation control material, may be composed of for example, 1 to 50 % by weight of the PVDF-HFP, 0.05 to 3 % by weight of the cross-linking agent, and a solvent as a remaining component.

Next, the thin film growth rate control ink is applied on the substrate in an engraved pattern (S3). The pattern formation control material is applied in a part in which a metal thin film is not to be formed on the substrate. The growth of the deposited thin film is affected by surface energy of the substrate, and when cohesion between metal atoms to be deposited is stronger than interaction with the lower substrate, it follows Volmer-Weber mode in which a film grows in an island form. In addition, some sources do not cause a condensation reaction on the surface on which the pattern formation control material is applied and a desorption phenomenon occurs complexly, and the growth rate of the deposited thin film is controlled. The pattern formation control material can be applied using various printing equipment (for example, inkjet printer, pneumatic dispenser, EHD printer), and the printed pattern formation control material has a flexible property that can be bent or stretched, so deposition-based patterning is possible even on a stretchable substrate or a substrate with curvature. For example, the prepared pattern formation control material is in an ink form and may be printed to form a certain pattern using a printing process.

In particular, when the metal electrode patterning method according to the examples of the present invention is applied in a roll-to-roll coating process on a flexible substrate, the pattern formation control material (thin film growth rate control ink) may be applied by a continuous production method, and may be coated over a large area. In addition, when deposition equipment capable of feeding a substrate by roll-to-roll is used, a separate mask aligning process is not required, so the metal electrode patterning method according to the examples of the present invention can be easily used in a large-area metal electrode patterning process.

The printing equipment may print a pattern to be implemented on a substrate, and according to the examples of the present invention, such a certain pattern may be freely produced and modified based on CAD (Computer-Aided Design) before printing.

In the region in which the pattern formation control material is applied on the substrate, the deposition rate is inhibited and a metal thin film is not formed, so a part except for the part where the metal pattern is to be loaded is patterned in intaglio to progress ink application. The thickness of the applied film is inside and outside about tens of nm ~ 10 µm, and the applied ink is used after heat-treating at a room temperature ~ 180°C, preferably, 100°C to 150°C. The line width of the pattern to be printed is limited by the ink application method of each process equipment, and when an EHD printer is used, it is possible to implement a fine pattern up to several tens of the line width at minimum, so even a fine pattern can be printed.

Then, an electrode is patterned on a substrate through metal deposition (S4). For example, the substrate in which the pattern formation control material is applied is transferred into a vacuum deposition chamber to progress metal deposition. As shown in (3) of FIG. 3, when deposition is progressed on the entire surface of the substrate in which the pattern formation control material (thin film growth rate control ink) is coated without using a separate mask, the metal is selectively deposited only in the region in which the pattern formation control material is not applied, so patterning is possible without applying an additional wet process. Referring to FIG. 4, in order to verify a selective patterning effect, first, silver (Ag) is used as a metal electrode patterning material to perform deposition. (a) of FIG. 4 shows a picture in which the pattern formation control material is applied on a glass substrate. The pattern formation control material is printed in a transparent ink form on a glass substrate, so the pattern under the glass substrate is seen as it is.

As shown in (b) of FIG. 4, the region in which the pattern formation control material is applied shows high transmittance as a metal thin film is not formed. Therefore, as same as the case of (a) of FIG. 4, on the glass substrate, the pattern under the region in which the pattern formation control material is applied is seen as it is. In addition, it can be confirmed that in the region in which the pattern formation control material is applied on the glass substrate, growth of the thin film is inhibited, so a characteristic of conduction is not shown. (c) of FIG. 4 illustrates the result of performing deposition using silver (Ag) as a metal electrode patterning material on the substrate. As shown, various metal electrode patterning can be performed by applying the pattern formation control material on the substrate.

The substrate having a metal electrode pattern prepared by the aforementioned method comprises a region in which a conductive metal pattern is printed on a substrate and a region in which a pattern formation control material is applied on a substrate. Then, the region in which a pattern formation control material is applied is formed by printing and drying the pattern formation control material by a printing process. In addition, the region in which a pattern formation control material is applied has light transmittance, and the conductive metal pattern is a high-purity metal pattern formed by PVD.

At this time, as the metal pattern on the substrate, a high-purity metal pattern is formed by PVD. In addition, the size of the metal particles on the metal pattern is smaller than the particles in the region in which the pattern formation control material is applied, and the metal particles on the metal pattern are more uniformly distributed than the particles in the region in which the pattern formation control material is applied.

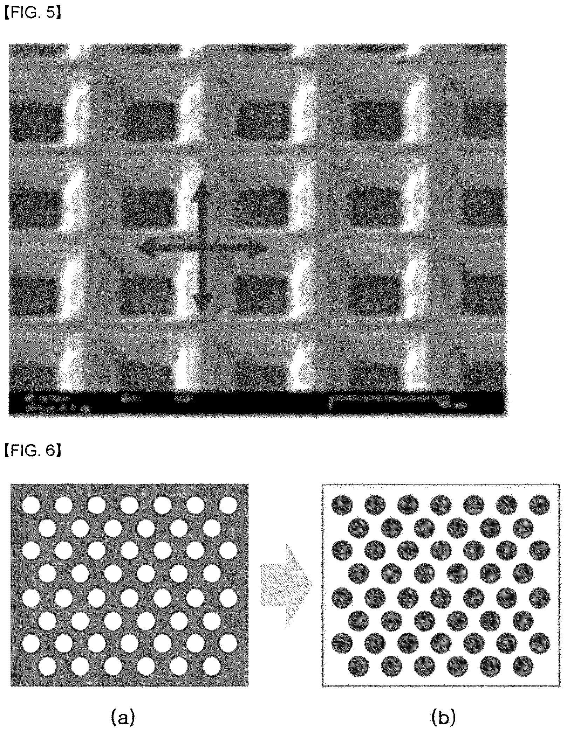

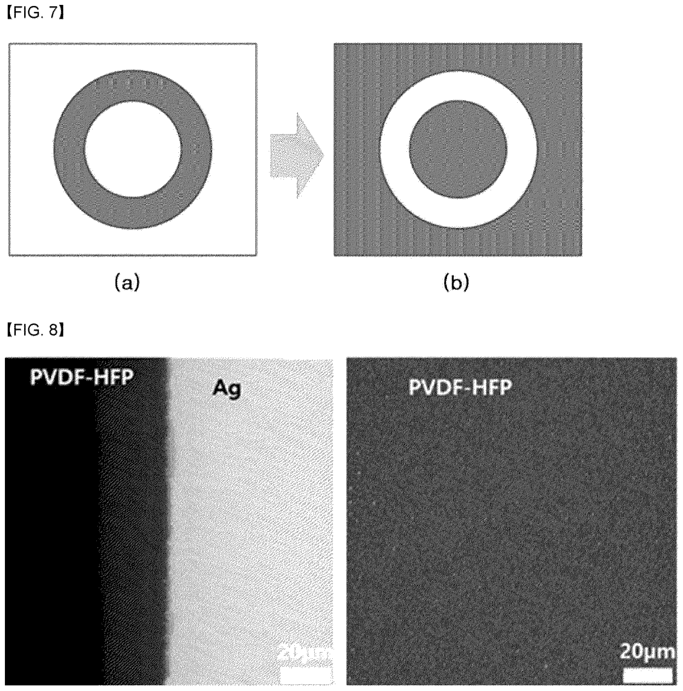

FIG. 5 is a drawing showing an example of a metal mask which can be practically manufactured, and FIGs. 6 and 7 are drawings to describe a formable metal electrode pattern using the metal electrode patterning method using a pattern formation control material according to one example of the present invention.

Referring to FIG. 5 to FIG. 7, in case of manufacturing an actual metal mask, it cannot be manufactured in a form in which an alloy material, which is a main material, is completely separated, and it should be processed in a connected state (arrow in FIG. 5). Due to such a limitation, a limitation occurs in the shape of the metal electrode pattern using a conventional metal mask. For example, with a conventional metal mask, patterning with a hole-formed pattern, a ring-shaped pattern, or the like is difficult.

For example, in order to implement the technology of an under display camera (UDC) in which a camera is arranged under a display to implement a full screen, it is required to secure transmittance of an OLED display, and due to this, as (b) of FIG. 6, it has been developed in a direction of increasing an aperture ratio by forming a hole-formed pattern in a cathode deposited on the entire surface. In order to implement this pattern, the metal mask should be formed in a form such as an independent dot as (b) of FIG. 6. However, in this case, the dot-shaped members of the metal mask are not connected each other, so such a metal mask cannot be implemented. Therefore, using a conventional metal mask, such a hole-formed pattern cannot be deposited.

In addition, as FIG. 7, there is difficulty also in forming a ring electrode pattern for measuring bio-signals with a metal mask for the same reason.

On the other hand, according to the metal electrode patterning method using a pattern formation control material according to the examples of the present invention, a mask is not used at all through the entire process steps, so a hole-formed pattern and a ring-shaped pattern which are difficult to pattern with a single mask can be formed at one time.

FIG. 8 is drawings showing the selective patterning result of Ag by the metal electrode patterning method using a pattern formation control material according to one example of the present invention.

Referring to FIG. 8, comparing the region in which the pattern formation control material is applied comprising PVDF-HFP and the region in which the pattern formation control material is not applied when Ag is deposited in a thickness of 100 nm, it can be confirmed that deposition is effectively controlled by the pattern formation control material. In some regions in which the pattern formation control material is applied, the deposited Ag is formed in an island form with a size of about 200nm or less, preferably, about 100 nm or less, but it is only a trace amount, so it shows optically transparent characteristics, and no nuclei grow, and thus, a conduction path cannot be formed. Accordingly, using the pattern formation control material, a conductive metal pattern can be formed.

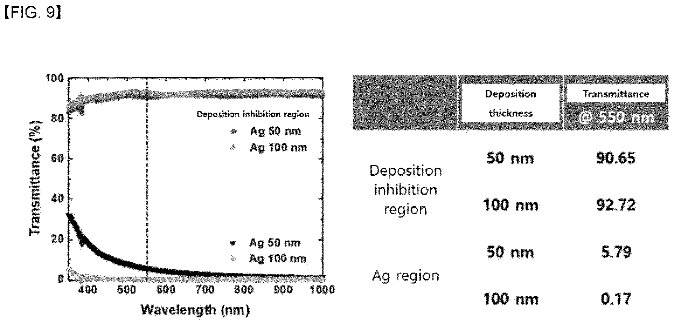

FIG. 9 is a drawing showing the result of measuring transmittance of the Ag region/PVDF-HFP applied region illustrated in FIG. 8.

Referring to FIG. 9, in order to compare the deposition inhibition effects between the regions in which the PVDF-HFP is applied and it is not applied, the patterning effect was confirmed by measuring transmittance and conductivity. As the deposition is inhibited in the PVDF-HFP region, the result shows high transmittance and high resistance characteristics. Referring to FIG. 8, as a result of measuring transmittance after deposition with a deposition thickness of 50 nm, 100 nm, respectively, unlike the sample in which Ag was deposited on the entire surface, to inhibit deposition, the result that the region in which PVDF-HFP was applied showed transmittance of 90% or more was shown. In addition, in the result of measuring the sheet resistance for comparison of the conductivity, it was confirmed that the Ag region showed low resistance of 0.48 ohm/sq when deposited at 50 nm, or 0.19 ohm/sq when deposited at 100 nm, while the PVDF-HFP-applied region showed high resistance characteristics beyond the range of 2 Mohm/sq capable of measuring using sheet resistance measuring equipment.

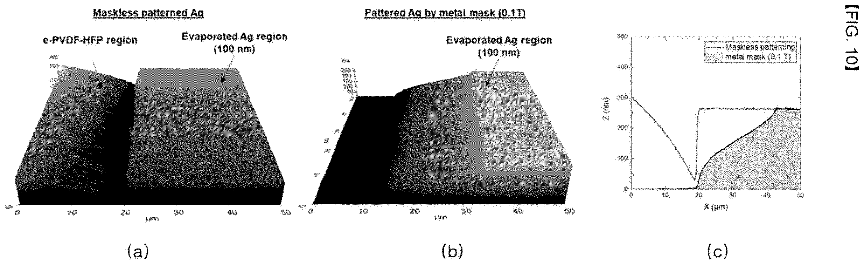

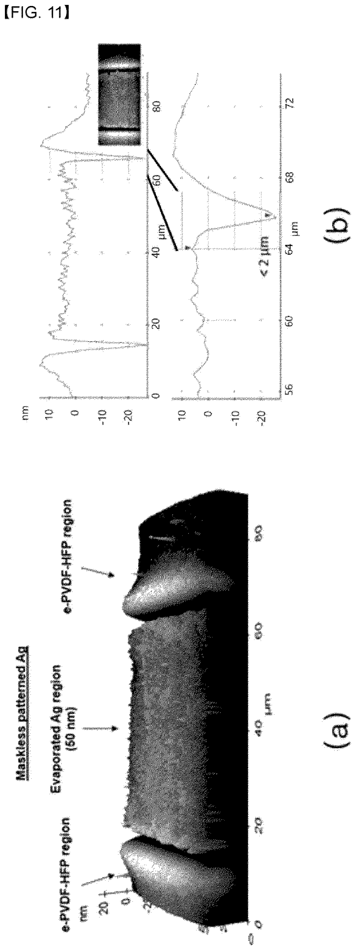

Through a metal thin film deposition test, it can be confirmed that the patterning effect is shown regardless of the deposition thickness. Using this point, it can be expected to be used in patterning of not only a metal electrode with a thin thickness (about several nm ~ 20 nm) used for transparent electrodes, but also a metal electrode having high conductivity and high reflection characteristics (> 50 nm), so it is expected to be used as an electrode for implementing various electric and electronic circuits and driving electronic devices. FIG. 10 is drawings showing one example of shapes in which a shadow effect is improved by the metal electrode patterning method using a pattern formation control material according to one example of the present invention, and FIG. 11 is drawings showing another example of shapes in which a shadow effect is improved by the metal electrode patterning method using a pattern formation control material according to one example of the present invention.

Referring to FIG. 10, (a) of FIG. 10 is a cross-sectional shape of the metal pattern formed using the electrode patterning method by the examples of the present invention, and (b) of FIG. 10 is a cross-sectional shape of the metal pattern formed using a conventional metal mask, and (c) of FIG. 10 is a graph schematizing the cross-sectional shapes shown in (a) and (b) of FIG. 10.

As shown in FIG. 10, the electrode patterning method by the examples of the present invention does not use a mask at all, so a shadow effect shown when a mask is used can be improved. The shadow region formed due to the thickness of the mask and the gap with a target substrate is considered to be one of causes of lowering the deposition resolution. On the other hand, using the method according to the examples of the present invention, only the region without e-PVDF-HFP is selectively film-formed, so the shadow region is reduced at the boundary part of the electrode.

As shown in (a) and (c) of FIG. 10, according to the metal electrode patterning method by the examples of the present invention, in the region in which the deposition inhibition material is applied, the metal electrode pattern cannot be deposited, and in the region in which no deposition inhibition material is applied, the shadow effect is not caused. Due to this, the metal electrode pattern is deposited even in the region adjacent to the region in which the deposition inhibition material is applied without any limitation, so the cross section of the interface (corner) of the metal electrode pattern, in other words, the transition region may comprise an inclined surface having an angle of about 0.5° to about 10° with respect to the substrate.

In case of forming a metal electrode pattern using the metal electrode patterning method by the examples of the present invention, improvement of the shadow effect is possible, and thereby, the length of the transition region at the corner profile toward the boundary of the electrode is less than about 10 µm, preferably, less than about 5 µm, and more preferably, less than about 3 µm.

On the other hand, as shown in (b) and (c) of FIG. 10, in the metal electrode patterning method using a conventional metal mask, due to the shadow effect of the metal mask, the metal electrode pattern limits deposition in the region adjacent to the region in which the deposition inhibition material is applied, so the cross-sectional shape of the interface of the metal electrode pattern is inevitably formed in an incline form with respect to the substrate. As a result, the metal electrode patterning method using a conventional metal mask has low deposition resolution compared to the present invention.

Specifically, when an electrode is deposited using a metal mask (thickness 100 µm), the corner profile at the boundary of the electrode is not neatly formed due to the shadow effect, and the distance of the transition region (inclined surface shown in (b) of FIG. 10) formed due to the shadow effect is about 45 µm.

Therefore, the metal electrode patterning method by the examples of the present invention can form an electrode with high resolution compared to the case of using a metal mask.

The example shown in FIG. 11 is an example of a fine line width electrode pattern formed after printing a pattern formation control material using EHD printing. As the example shown in FIG. 10, when a metal electrode pattern is formed using aa metal electrode patterning method by the examples of the present invention, improvement of the shadow effect is possible, and thereby, the shorter the length of the transition region in the corner profile at the boundary of the electrode is preferable in terms of resolution, and the length of the transition region is less than about 10 µm, preferably, less than about 5 µm, and more preferably, less than about 2 µm.

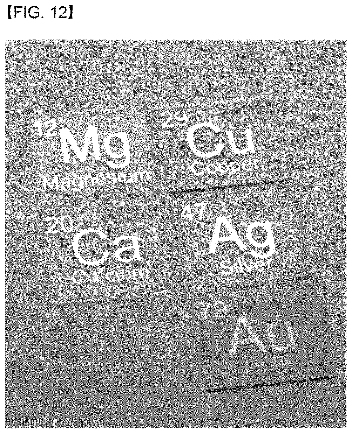

FIG. 12 is a drawing showing results of printing various metal materials by the metal electrode patterning method using a pattern formation control material according to one example of the present invention.

In the above description, selective patterning of Ag has been described, and in addition thereto, selective patterning with various metal materials is possible. For example, as shown in FIG. 12, selective patterning also with metal materials such as magnesium (Mg), copper (Cu), Calcium (Ca), silver (Ag), gold (Au) and the like is possible. However, the metal materials capable of selective patterning are not limited to the aforementioned, and metal materials capable of vacuum deposition may be included in the example of the present invention.

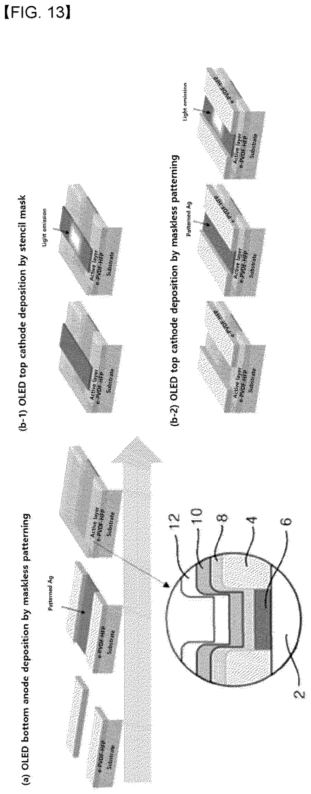

FIG. 13 is a drawing showing a process of forming an electrode pattern by the metal electrode patterning method using a pattern formation control material according to one example of the present invention.

First, referring to (a) of FIG. 13, a region in which a pattern formation control material is printed (4) in the upper portion of a substrate (2) is formed, and a metal is deposited in a region other than the region in which a pattern formation control material is printed (2) to form a lower anode (6). In the upper portion of the lower anode (6), an electron-related organic layer (8), an organic light emitting layer (EML, 10) and a hole-related organic layer (12) may be laminated.

On the lower anode (6) of the substrate (2), an electron-related organic layer (8) having a structure in which an electron transport layer (ETL) and an electron injecting layer (EIL) are laminated is formed. The electron injecting layer (EIL) plays a role of facilitating electron injection from an electrode. The electron transport layer (ETL) delivers an electron from the electron injecting layer (EIL) to the light emitting layer (EML).

On the electron-related organic layer (8), a light emitting layer (EML) is formed. The light emitting layer (EML) emits light as a fluorescent or phosphorescent material emits light by energy generated by bonding action of holes supplied through a hole transport layer (HTL) and electrons supplied through an electron transport layer (ETL).

On the light emitting layer (EML), a hole-related organic layer (12) having a structure in which a hole injecting layer (HIL) and a hole transport layer (HTL) are laminated is formed. The hole injecting layer (HIL) plays a role of facilitating hole injection from the electrode. The hole transport layer (HTL) delivers the hole from the hole injecting layer (HIL) to the light emitting layer (EML).

Next, referring to (b-1) of FIG. 13 and (b-2) of FIG. 13, an upper cathode may be formed on the active layer. The case of (b-1) shows the case of using a mask, and the case of (b-2) shows an example in which an upper cathode is formed by the metal electrode patterning method using a pattern formation control material according to one example of the present invention.

In other words, in the upper portion of the active layer, a region in which a pattern formation control material is printed is formed, and in a region other than the region in which the pattern formation control material is printed, a metal is deposited to form an upper cathode. On the other hand, in the example shown in (a) of FIG. 13, the order in which each layer is laminated on the substrate (2) is only an example, and if necessary, the order in which each layer is laminated may be changed. For example, on the substrate (2), a cathode, a hole-related organic layer in the upper portion of the cathode, an organic light emitting layer, an electron-related organic layer and an anode may be laminated.

The above description is illustratively describing the technical spirit of the present invention only, and those skilled in the art to which the present invention belongs can make various modification and variation in a range without departing from essential characteristics of the present invention. Therefore, the examples disclosed in the present invention are not intended to limit the technical spirit of the present invention, but are intended to describe it, and the scope of the technical spirit of the present invention is not limited. The scope of the present invention should be construed according to the claims below, and all the technical spirits within the equivalent range thereto should be construed as being included in the scope of the present invention.

## Claims

1. A metal electrode patterning method using a pattern formation control material, comprising preparing a substrate;
printing a pattern formation control material on a substrate in an engraved pattern; heat-treating the printed pattern formation control material; and
forming a conductive metal electrode pattern in a region other than the engraved pattern-printed region,
in which the region where the pattern formation control material is printed has light transmission.

2. The metal electrode patterning method using a pattern formation control material according to claim 1,
wherein the metal electrode pattern is a high-purity metal electrode pattern formed by physical vapor deposition (PVD).

3. The metal electrode patterning method using a pattern formation control material according to claim 1,
further comprising designing the engraved pattern before the printing the engraved pattern on the substrate.

4. The metal electrode patterning method using a pattern formation control material according to claim 1,
wherein the pattern formation control material is ink comprising PVDF-HFP (Poly(vinylidene fluoride-co-hexafluoropropylene)).

5. The metal electrode patterning method using a pattern formation control material according to claim 4,
wherein the pattern formation control material further comprises a solvent, and
the solvent comprises one alone selected from the group consisting of NMP (N-methyl-2-pyrrolidone), TEP (Triethyl phosphate), DMSO (Dimethyl sulfoxide), MIBK (Methyl isobutyl ketone), and PGMEA (Propylene glycol methyl ether acetate), or a mixture thereof.

6. The metal electrode patterning method using a pattern formation control material according to claim 5,
wherein the pattern formation control material further comprises a cross-linking agent, and the cross-linking agent comprises one alone selected from the group consisting of TAIC (1,3,5-Triallyl-1,3,5-triazinane-2,4,6-trione, BPO (dibenzoyl peroxide), DCP (Dicumyl peroxide), PBP (Perbutyl peroxide), MIKP (Methyl isobutyl ketone peroxide), and Dimethyl Di-t-butylperoxy hexane, or a mixture thereof.

7. The metal electrode patterning method using a pattern formation control material according to claim 5,
wherein the pattern formation control material comprises 1 to 50 % by weight of the PVDF-HFP, 0.05 to 3 % by weight of the cross-linking agent and the solvent as a remaining component.

8. The metal electrode patterning method using a pattern formation control material according to claim 1,
wherein the engraved pattern comprises a plurality of printing regions in which the pattern formation control material is printed, and
each of the printing regions is not connected to other printing regions.

9. The metal electrode patterning method using a pattern formation control material according to claim 8,
wherein the metal electrode pattern forms a pattern consisting of dot, circle, oval, polygon and ring shapes or a combination thereof.

10. The metal electrode patterning method using a pattern formation control material according to claim 1,
wherein the heat-treating is performed in a temperature range of 100°C to 150°C.

11. The metal electrode patterning method using a pattern formation control material according to claim 1,
wherein metal particles on the metal electrode pattern are more uniformly distributed than particles distributed in the region in which the pattern formation control material is applied.

12. The metal electrode patterning method using a pattern formation control material according to claim 1,
wherein a transition region is formed between the region in which the metal electrode pattern is formed and the region in which the pattern formation control material is printed.

13. The metal electrode patterning method using a pattern formation control material according to claim 12, wherein the transition region comprises an inclined surface having an angle of 0.5° to 10° with respect to the substrate.

14. The metal electrode patterning method using a pattern formation control material according to claim 13, wherein the length of the transition region is 10 µm or less.

15. The metal electrode patterning method using a pattern formation control material according to claim 1, wherein the size of the metal particles formed in the region in which the pattern formation control material is applied is smaller than 200nm.

16. The metal electrode patterning method using a pattern formation control material according to claim 1, wherein the metal deposited on the substrate comprises one alone selected from the group consisting of gold (Au), silver (Ag), magnesium (Mg), copper (Cu), iron (Fe), and
calcium (Ca) or a combination thereof.

17. The metal electrode patterning method using a pattern formation control material according to claim 1, wherein the formation of the metal electrode pattern is performed by a roll-to-roll deposition method.

18. A substrate having a metal electrode pattern,
comprising a region in which a pattern formation control material is printed on the substrate; and
a region in which a conductive metal electrode pattern is formed on the substrate,
wherein the region in which the metal electrode pattern is formed is a region other than the region in which the pattern formation control material is printed, and
the region in which the pattern formation control material is printed is formed by printing and drying the pattern formation control material by a printing process and has light transmission, and
the metal electrode pattern is a high-purity metal electrode pattern formed by PVD.

19. The substrate having a metal electrode pattern according to claim 18, wherein metal particles on the metal electrode pattern are more uniformly distributed than particles distributed in the region in which the pattern formation control material is applied.

20. The substrate having a metal electrode pattern according to claim 18, wherein a transition region is formed between the region in which the metal electrode pattern is formed and the region in which the pattern formation control material is printed.

21. The substrate having a metal electrode pattern according to claim 20, wherein the transition region comprises an inclined surface having an angle of 0.5° to 10° with respect to the substrate.

22. The substrate having a metal electrode pattern according to claim 20, wherein the length of the transition region is 10 µm or less.

23. A display, comprising
a substrate;
a region in which a pattern formation control material is printed on the substrate;
a region in which a conductive metal electrode pattern is formed on the substrate; and
at least one light emitting device electrically connected to the metal electrode pattern, wherein the region in which the metal electrode pattern is formed is a region other than the region in which the pattern formation control material is printed, and
the region in which the pattern formation control material is printed is formed by printing and drying the pattern formation control material by a printing process and has light transmission, and
the metal electrode pattern is a high-purity metal electrode pattern formed by PVD.

24. The display according to claim 23,
wherein the region in which the pattern formation control material is printed is formed on the upper portion and lower portion of the light emitting device, respectively, and
the metal electrode pattern is formed in a region other than the pattern formation control material is printed and is electrically connected to the light emitting device.

25. An electronic apparatus, comprising
a substrate;
a region in which a pattern formation control material is printed on the substrate;
a region in which a conductive metal electrode pattern is formed on the substrate; and
at least one electronic device electrically connected to the metal electrode pattern,
wherein the region in which the metal electrode pattern is formed is a region other than the region in which the pattern formation control material is printed, and
the region in which the pattern formation control material is printed is formed by printing and drying the pattern formation control material by a printing process and has light transmission, and
the metal electrode pattern is a high-purity metal electrode pattern formed by PVD.
